# EUROPEAN PATENT APPLICATION

(11) **EP 2 500 776 A2**
(43) Date of publication of application: **19.09.2012**
(21) Application number: 11008132.0
(22) Date of filing: 07.10.2011
(51) Int. Cl.: G03F 7/20

(54) **Method for optimization of photoresist exposure parameters in photolithography process and device for implementing the method**

(30) Priority: 17.03.2011 PL 39425011
(71) Applicant: Instytut Technologii Elektronowej, 02-668 Warszawa (PL)
(72) Inventor: Sierakowski, Andrzej, 05-500 Piaseczno (PL); Domanski, Krzysztof, 05-500 Piaseczno (PL); Janus, Pawel, 05-840 Brwinow (PL); Grabiec, Piotr, 96-321 Osowiec (PL); Gotszalk, Teodor Pawel, 52-230 Wroclaw (PL)
(74) Representative: Gizinska-Schohe, Malgorzata

(57) **Abstract**

The subject of the present invention is a method for determining the optimal exposure parameters in a photolithography process by analysis of topographic profiles of exposed images in a photoresist layer and a device for implementing of the method.

According to the invention the optimal exposure parameters in the photolithography processes are determined as follows: in a first step a test area (OT) on a substrate coated with a photoresist is determined. Then in the test area (OT) a test pattern (WT) is exposed at least twice, each time under different exposure parameters, such as exposure energy and/or focus of the optical system. All test patterns (each exposed under different conditions) are scanned in at least 10 points along a straight line, recording the heights of photoresist layer in those points forming topography profiles. After then the profile with the smallest angle between a section in the middle part of the profile connecting the local minimum and maximum and the vertical axis is selected and the exposure parameters for this very profile are determined as optimal.

The device for determining the optimal exposure parameters in a photolithography process comprises a scanning probe head integrated with a system for maskless lithography, so that the movement of the scanning probe is recorded in the coordinates of the exposure system.

The method and device allow for easy recognition, which areas of the photoresist layer were appropriately exposed and which was not, without the need of conducting a photoresist developing step. Analysis of the measured topography profiles as obtained by scanning in selected regions of the test area allows determining whether the exposure parameters were appropriate.

## Description

The subject of the present invention is a method for determining the optimal photoresist exposure parameters in a photolithography process by analysis of topographic profiles of exposed images in a photoresist layer and a device for implementing the method. The method and the device of the present invention allow for determining the optimal exposure parameters immediately after exposing a photoresist (a light sensitive polymer) coated on a substrate with omitting a development step.

Because in a photolithography process a photoresist layer changes its parameters during exposure, and also the thickness of the photoresist layer undergoes an alternation in exposed areas, therefore the correctness of the initial selection of parameters such as exposure energy (also called exposure dose) or exposure time, setting a focus of an optical system, and minimizing a stitching error, can be deducted by measuring the surface topography of the photoresist layer (so called latent images) immediately after the exposure.

US Patent No. 6,500,591 discloses a method employing a dark field microscope for deducting on correctness of setting a focus of an optical system. This method involves checking the exposed areas immediately after exposure, and registration of the intensity of light reflected from the photoresist. A dark field microscope uses a disperse light for illumination of the tested area (lighting comes from the direction that is not parallel to the optical system axis direction) and therefore allows observing rapid changes in the surface topography of the photoresist layer (so called latent images) that appear on the edge of the pattern (the boundary region between the exposed and unexposed areas). Assuming that the highest intensity of the reflected light is recorded under the optimal settings of the optical focus parameter, it is possible to carry out the procedures for optimization of this parameter without the need of conducting a photoresist development step.

The disadvantage of the above method for selecting a focus parameter for an optical system is the necessity to conduct the test with using the optimal exposure energy. Testing procedures carried out under other conditions do not give satisfactory results.

The typical known method for minimizing a stitching error and optimizing exposure energy consists in an exposure of a testing pattern a few times, each time under different conditions, a development of the photoresist, and then analyzing the resulted patterns (choosing the best quality pattern), which allows determining the optimal exposure parameters of the photolithography process.

Conducting the above procedures for optimization of photoresist exposure parameters, i.e. determining the optimal exposure energy and minimizing the stitching error, requires developing a substrate with exposed test patterns, that significantly prolongs the time necessary to accomplish the trial procedures, and also requires using of additional test substrates with a photoresist layer.

The aim of the present invention is to provide a method for determining the optimal photoresist exposure parameters in a photolithography process, such as: exposure energy (or exposure time), setting a focus of an optical system, and minimizing a stitching error, without conducting a photoresist developing step; and a device for implementing this method.

According to the present invention a method for determining the optimal photoresist exposure parameters in a photolithography process is characterized in that first of all a test area on a substrate coated with a photoresist is determined. After that in the test area a test pattern is exposed a few times, at least twice, each time under different exposure parameters, such as exposure energy, and/or focus of an optical system. After each change of the exposure parameters the test area with the test patterns formed (each exposed with different conditions) is scanned in at least 10 points along a straight line recording the height of photoresist layer in each of those points forming a topography profile. Next the profile with the smallest angle between a section in the middle part of the profile connecting the local minimum with the local maximum and the vertical axis is selected and the exposure parameters for this very profile are determined as optimal, and consequently the exposure parameters for this very profile are determined as optimal for exposing a final design in the entire photoresist layer on the substrate.

In another modification of the method of the present invention, first of all the test area containing at least two bordered areas of scan is determined, and next at least two lines passing by the areas of scan and being perpendicular to their edges are exposed using a scanning method, each time under different exposure parameters which have influence on a stitching error. After each change of the exposure parameters the test area is scanned in at least 10 points along at least two straight lines that are perpendicular to the lines previously generated. Next the heights of photoresist layer in each of those scanned points forming topography profiles are recorded. The local extremes represent the center of the previously generated lines in the topography profiles. The relative positions of the local extremes (measured in a perpendicular direction to the lines previously generated) in the obtained profiles are analyzed. Finally the exposed line in which the relative distance between local extremes is the smallest is selected. The exposure parameters used for exposing this line are determined as optimal for exposing a final design in the entire photoresist layer on the substrate.

A device according to the invention comprises a scanning probe head integrated with a system for maskless lithography, so that the movement of the scanning probe head is recorded by a control unit in the coordinates of the exposure system stage.

The method and device of the present invention allow for easy recognition, which areas of the photoresist layer were appropriately exposed and which was not, without the need of conducting a photoresist developing step. Whereas the analysis of the measured topography profiles as obtained by scanning in selected regions of the test area allows determining whether the exposure parameters were appropriate.

Two working examples of the present invention will be presented closer on figures. Fig. 1 shows the test area with the exposed pattern; Fig. 2 shows the test area with two bordered areas of scan. Fig. 3 shows the block diagram of the system for maskless lithography DWL (Direct Writing Lithography) connected with the head comprising a scanning probe microscope SPM (Scanning Probe Microscope). Fig. 4 shows the atomic force microscopy image (AFM images) of the test area that contains two test patterns exposed in positive photoresist (*Shipley 1805)* with different process parameters. Fig. 5 shows the test area that contains two alignment marks exposed in separated photolithography processes.

For realization of the method of the present invention the system for maskless lithography, i.e. the direct writing lithography DWL system with the head comprising the scanning probe microscope SPM as an additional module was use. The head can work in any measurement mode of interaction between the tip of the scanning probe microscope SPM and the test area OT under examination (in the example, the force measurement). The SPM probe is mounted to piezoelectric positioners marked as Pz and Pxy. The control unit JS controls the positioner Pz to maintain a constant affecting value via regulating the distance between the tip of the SPM probe and the test area OT. At the same time, the control unit JS controls the positioner Pxy and records the position of the piezoelectric positioner Pxy relative to actual coordinates of the stage ST in the direct writing lithography DWL system. Recorded distance between the tip of the SPM probe and the test area OT, in particular its measurement points, as well as the position of the positioner Pxy recorded for each point in coordinates of the stage ST in the direct writing lithography DWL system, give information about the test area OT topography (and profile). Positioner Pxy moves the tip of the SPM probe relative to the x and y axes, and the actual SPM probe position is read by sensors Rxy, in the example strain gauges are used.

Since the head with the SPM probe is placed over the movable stage ST of the direct writing lithography DWL system, and the positioner Pxy and the stage ST are moving in parallel planes, this configuration enables measuring the test area OT in a substrate coated with a photoresist that is located on the stage ST using the SPM probe. The control unit JS controls positions of both mobile elements, i.e. the tip of the SPM probe mounted to the positioner Pxy and the stage ST. The system configuration makes possible to determine their relative position in the control coordinates of the DWL system, and consequently enables studying the topography at the specified regions of the test area OT.

The analysis of the measured profiles is made immediately after the exposure of the photoresist layer coated on a substrate, without the necessity of its removal from the stage ST of the DWL system.

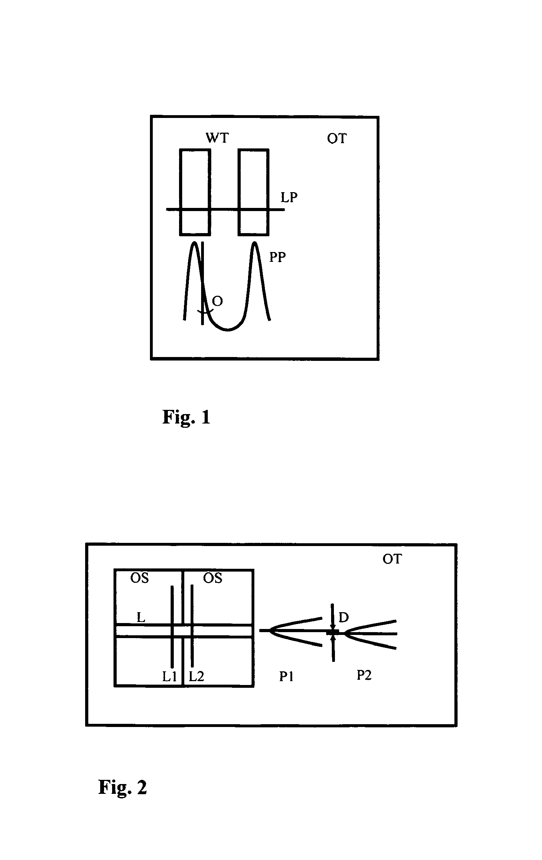

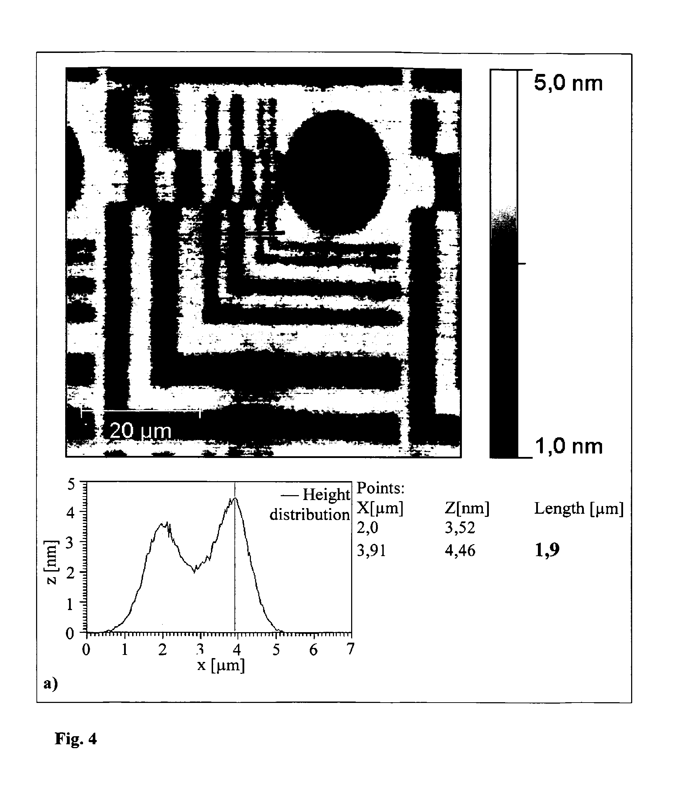

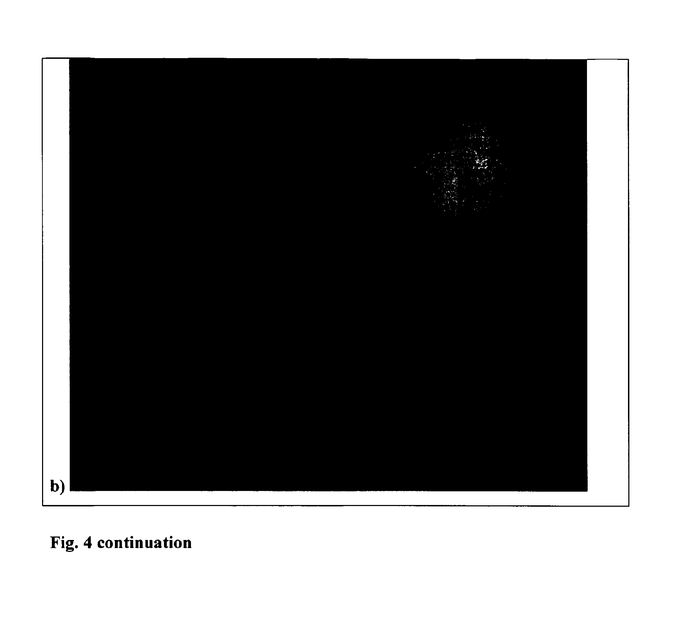

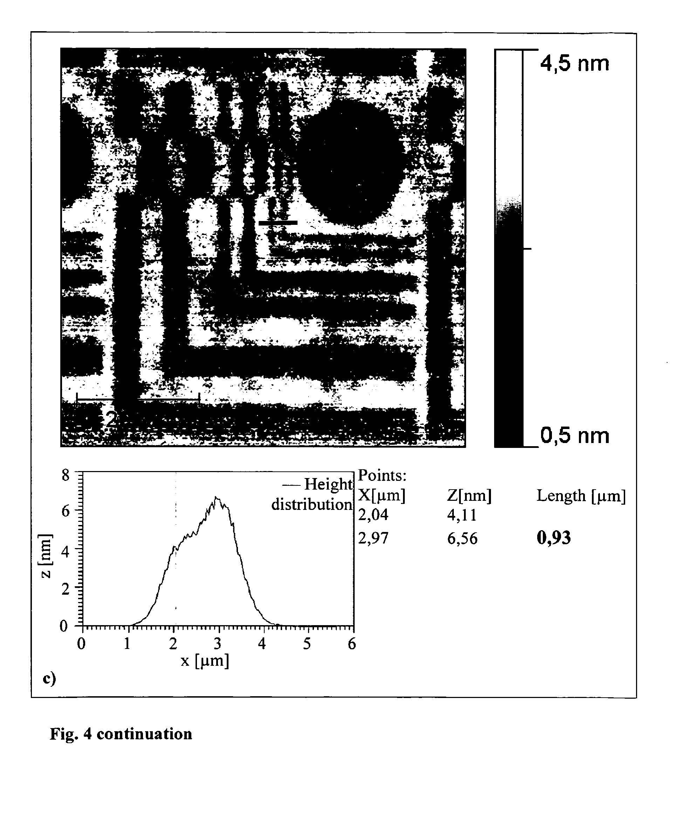

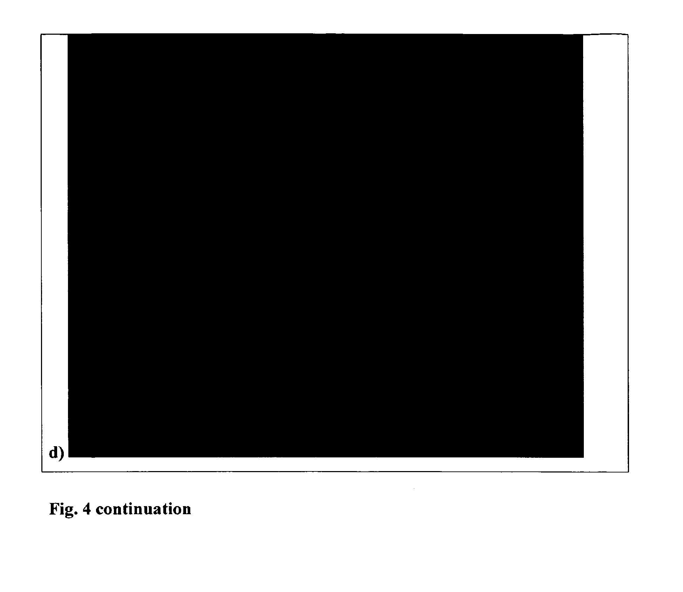

In the first example the optimal exposure process parameters for the positive photoresist *(Shipley 1805)* coated on a substrate were defined immediately after the exposure. On the substrate the test area OT was selected close to the substrate edge. The test area OT has dimensions 50 x 50 µm. In the test area OT the test pattern for the following combination of parameters was exposed: changing twice the exposure energy (30 mW, 50 mW), changing three times the settings of the optical system focus (-20 µm, 0 µm, +20 µm); and changing three times the settings of the Acoustic Optic Deflector in view of a stitching error (AOD = 1950, AOD = 1960, AOD = 1970). In DWL systems a stitching error strongly depends on the Acoustic Optic Deflector parameter. After each exposure with a different parameter configuration the test area OT with a test image obtained (a latent image as before development) was scanned with the tip of the SPM probe placed above the test area OT and the results were recorded separately. On the test area OT 100 points along a straight line LP (shown in Fig. 1) of 7.5 µm length (black lines marked on the microscopic images in Fig. 4) were scanned.

As a result of this scanning the topography profiles of the height of photoresist layer were obtained as a function of horizontal coordinates. On the test areas OT the obtained test image was examined at the place where the two lines WT with a width of 1 µm and in a spacing of 1 µm between the two lines were exposed. As a scanning result for each test area OT a profile PP (Fig. 1 and Fig. 4) was obtained. For the optimal profile, the angle (angle O shown in Fig. 1) between the section in a middle part of a profile connecting the local minimum and local maximum and the vertical axis is the smallest one (i.e. the horizontal distance between the two local extremes is minimal).

Fig. 4a and Fig. 4c show the measurement results of two test areas exposed with different exposure parameters. The test area OT presented in Fig. 4a was exposed with the exposure energy 50 mW, the optical system focus 0 µm and the Acoustic Optic Deflector AOD = 1960. The test area OT presented in Fig. 4c was exposed with the exposure energy 30 mW, the optical system focus 0 µm and the Acoustic Optic Deflector AOD = 1960. The areas of scan of the photoresist layer profiles were marked with black lines. Both test areas have the same photoresist layer (0.5 µm thick, *Shipley 1805).* For clarity of the example the whole test areas OT were scanned, but only a scan result in 100 points along a straight line LP (7.5 µm length) (Fig. 1 and black lines marked on Fig. 4) was analyzed. The obtained profiles were analyzed immediately after exposure (i.e. without development of a process pattern in the photoresist layer). The profile presented in Fig. 4a has distinct maxima, which correspond to the two lines WT, each being of 1 µm width, and separated one from another by 2 µm. The profile shown in Fig. 4c was exposed in a photoresist layer with the exposure energy of 30 mW. In this profile there were not observed any apparent maxima. The same test areas OT after developing of images in the photoresist layer are shown in Fig. 4b and Fig. 4d, respectively. Fig. 4b presents the test area OT exposed with the correct exposure parameters. The structure shown in the Fig. 4d is underexposed; it means that the exposure energy of 30 mW was too small. The analysis of measured profiles shows that the optimal photoresist exposure parameters are the same as those used for exposing the test area OT shown on Fig. 4a, i.e. where the exposure energy was 50 mW, the optical system focus was 0 µm and the Acoustic Optic Deflector AOD = 1960. The exposure parameters employed for the photoresist exposure with the profile presented in Fig. 4a were used during exposing a final design.

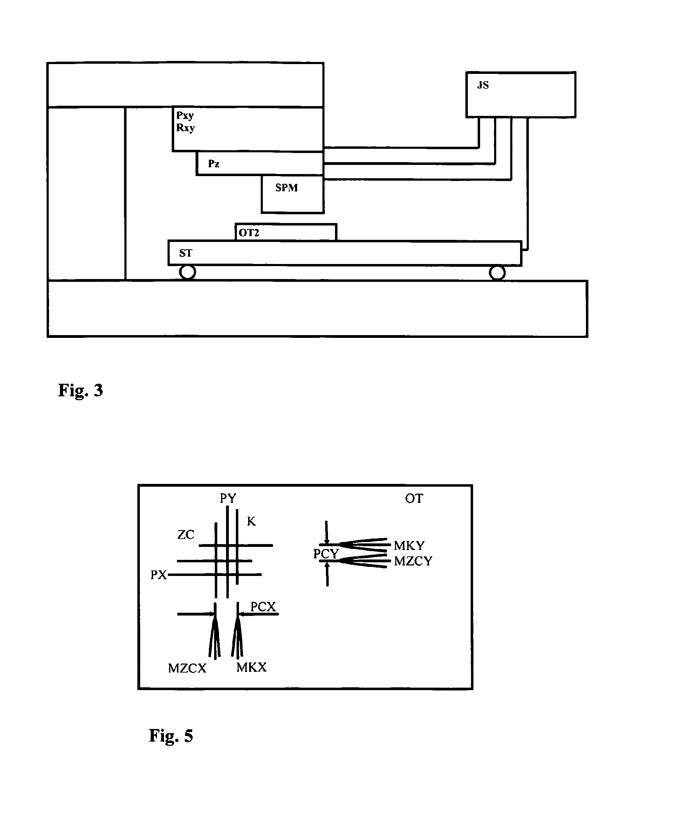

In the second example (Fig. 5), a substrate with the test area OT containing the alignment mark ZC formed in previous photolithographic process was covered by photoresist. After pre-aligning in close distance to the alignment mark ZC a test pattern K (cross with arms of 20 µm length and 2 µm width - similar to the alignment mark ZC) was exposed. In next step the test area with just exposed test pattern K and existing alignment marks ZC was scanned along a straight perpendicular lines PX and PY. In obtained profiles extremes MZCX and MZCY appoint the center ZC of the alignment mark in both directions. By analogy extremes MKX and MKY appoint the center of the test pattern K in both directions. The test was performed in four test areas OT on the substrate. For each tested area the PCX and PCY alignment corrections were calculated and used for correct pre-aligning procedure. In the next step a final design was exposed on the same substrate with satisfactory overlay accuracy.

The method of the invention and the device for implementing the method allows optimizing exposure parameters without conducting any photoresist developing step. The test areas are relatively small (about 50 x 50 µm) and appropriate deployment on substrate enables to set the optimum parameters without using any additional test substrates.

## Claims

1. A method for determining the optimal exposure parameters in a photolithography process **characterized in that** a tests area (OT) on a substrate coated with a photoresist is determined, in the tests area (OT) a test pattern (WT) is exposed a few times, at least twice, each time under different exposure parameters, such as exposure energy, and/or focus of an optical system, after each change of the exposure parameters the test area (OT) with the exposed test pattern (WT) is scanned in at least 10 points along a straight line (LP) recording the height of photoresist layer in each of those points forming a topography profile (PP), and then the profile (PP) with the smallest angle (O) between a section in the middle part of the profile connecting the local minimum with the local maximum and the vertical axis is selected, and the exposure parameters for this very profile are determined as optimal for exposing a final design on the substrate.

2. The method according to claim 1, **wherein** the test area (OT) containing at least two bordered areas of scan (OS) is determined, at least two lines (L) passing by the areas of scan (OS) and being perpendicular to their edges are exposed using a scanning method, each time under different exposure parameters which have influence on a stitching error, and after each change of the exposure parameters the test area is scanned in at least 10 points along at least two straight lines (L1, L2) that are perpendicular to the lines (L) previously generated, next the heights of photoresist layer in each of those scanned points forming topography profiles are recorded and the relative positions of the local extremes in the obtained profiles are analyzed and the line (L) with the smallest relative distance (D) between local extremes measured in a perpendicular direction to the lines previously generated is selected, and the exposure parameters for this very line are determined as optimal for exposing a final design on the substrate.

3. The method according to claim 2, **wherein** the test area (OT) contains a pattern with known geometry below a photoresist layer.

4. The method according to claim 2, **wherein** the test area (OT) contains alignment marks.

5. A device for determining the optimal exposure parameters in a photolithography process **characterized by** comprising a scanning probe head (SPM) integrated with a system for maskless lithography, so that the movement of the tip of the scanning probe head (SPM) is recorded by a control unit (JS) in the coordinates of the exposure system stage (ST) of the system for maskless lithography.
